# EUROPÄISCHE PATENTSCHRIFT

(11) **EP 3 344 794 B1**
(45) Veröffentlichungstag und Bekanntmachung des Hinweises auf die Patenterteilung: **30.10.2024**
(21) Anmeldenummer: 15757510.1
(22) Anmeldetag: 03.09.2015
(51) Int. Cl.: C23C 16/511, C23C 16/458, C23C 16/52, H01J 37/32, C23C 16/27, C30B 29/04, C23C 16/02, C30B 25/12, C30B 25/20

(54) **BESCHICHTUNGSVERFAHREN**
COATING METHOD
PROCÉDÉ DE REVÊTEMENT

(43) Veröffentlichungstag der Anmeldung: 11.07.2018
(73) Patentinhaber: Fraunhofer-Gesellschaft zur Förderung der angewandten Forschung e.V., 80686 München (DE)
(72) Erfinder: NEBEL, Christoph E., 79102 Freiburg (DE); MÜLLER-SEBERT, Wolfgang, 79112 Freiburg (DE)
(74) Vertreter: Friese Goeden Patentanwälte PartGmbB
(86) Internationale Anmeldenummer: PCT/EP2015/070184
(87) Internationale Veröffentlichungsnummer: WO 2017/036543

(56) Entgegenhaltungen:
- EP-A1- 0 822 572
- DE-C1- 19 507 077
- US-A- 5 479 875
- US-A- 5 704 976
- US-A1- 2003 084 839
- US-A1- 2011 092 073
- US-A1- 2015 159 268

## Beschreibung

Die Erfindung betrifft ein Verfahren zur Beschichtung eines Substrates, bei welchem das Substrat mit einem Substrathalter in einen evakuierbaren Rezepienten eingebracht wird, mit zumindest einer Gaszufuhreinrichtung zumindest ein gasförmiger Precursor in den Rezipienten eingeleitet wird und mit zumindest einer Plasmaerzeugungseinrichtung der Precursor zumindest teilweise ionisisiert wird. Vorrichtungen und Verfahren der eingangs genannten Art können beispielsweise zur epitaktischen Abscheidung dünner Schichten aus der Gasphase verwendet werden.

Die EP 0 822 572 A1 offenbart ein Hochfrequenzwellengerät und -verfahren, das eine relativ hohe Konzentration reaktiver Spezies aus einem Plasma bereitstellt. Das Plasma dient zur Behandlung einer Oberfläche, insbesondere eines Substrats (31) mit komplexer Geometrie in einem Halter (62), der einen Teil des Substrats maskiert. Bei den Hochfrequenzwellen handelt es sich vorzugsweise um Mikrowellen oder UHF-Wellen.

Aus der US 5,479,875 ist ein Verfahren zum Herstellen eines hochorientierten Diamantfilms mit verringerter Dicke bekannt. Die Oberfläche eines Einkristallsubstrats wird gereinigt und wird dann in einem Hochvakuum von 10⁻⁶ Torr oder weniger bei einer Temperatur zwischen Raumtemperatur und 800°C für 15 Minuten belassen, um auf der Oberfläche des Substrats absorbierte Gasmoleküle freizusetzen. Die Oberfläche des Substrats wird dann unter Verwendung von kohlenstoffhaltigem Plasma bearbeitet.

Die US 2003/084839 A1 offenbart eine Vorrichtung zum Herstellen von Diamant in einer Abscheidungskammer mit einem Kühlkörperhalter zum Halten eines Diamanten und zum Herstellen eines thermischen Kontakts mit einer Seitenfläche des Diamanten. Das Verfahren zum Herstellen von Diamant umfasst das Positionieren von Diamant in einem Halter, so dass ein thermischer Kontakt mit einer Seitenfläche des Diamanten angrenzend zu einer Kante einer Wachstumsoberfläche des Diamanten hergestellt wird. Sodann kann einkristalliner Diamant durch chemische Gasphasenabscheidung im Mikrowellen-Plasma auf der Wachstumsoberfläche hergestellt werden, wobei eine Wachstumsrate des Diamanten größer als 1 Mikrometer pro Stunde ist.

Aus der US 2011/092073 A1 ist eine Plasmabearbeitungsvorrichtung bekannt. Diese enthält einen evakuierbaren Bearbeitungsbehälter; eine Gaseinleitungseinheit, die ein Prozessgas in das Innere des Verarbeitungsbehälters einführt; eine Mikrowelleneinführungseinheit, die eine Mikrowelle in das Innere des Verarbeitungsbehälters einführt; und einen Hebestift, der durch eine im Inneren des Bearbeitungsbehälters vorgesehene Platzierungsplattform auf- und abwärts eingeführt wird, wobei eine Endfläche des Hebestifts einen zu bearbeitenden Gegenstand trägt.

Die US 5,704,976 A offenbart ein Verfahren zur Niederdrucksynthese von Diamant, bei welchem der Abstand zwischen der Plasmawolke und der Substratoberfläche veränderbar ist.

Aus der DE 195 07 077 C1 ist eine Vorrichtung und ein Verfahren der eingangs genannten Art bekannt. Diese bekannte Beschichtungsanlage umfasst einen Hohlraumresonator, welcher dazu eingerichtet ist, Mikrowellenstrahlung auf einen an die Substratoberfläche angrenzenden Raumbereich zu fokussieren. In diesen Raumbereich werden gasförmige Precursoren eingebracht, welche durch die Mikrowellenstrahlung ionisiert werden. Aus dem so entstehenden Plasma können einkristalline Diamantschichten auf dem Substrat abgeschieden werden.

Diese bekannte Beschichtungsanlage weist jedoch den Nachteil auf, dass sich das Plasma erst nach längerer Betriebsdauer stabilisiert. Dies führt dazu, dass zu Beginn der Schichtabscheidung Material niedrigerer Qualität abgeschieden wird. Beispielsweise können zu Beginn der Abscheidung von kristallinem Diamant auch graphitische Kohlenstoffphasen in der aufwachsenden Schicht enthalten sein. Bei der Abscheidung vergleichsweise dicker Schichten kann das anfangs aufwachsende Material geringer Qualität leicht entfernt werden, beispielsweise durch Schleifen oder Ätzen. In einigen Ausführungsformen kann ein geringer Anteil minderwertigen Materials an der Grenzfläche auch toleriert werden, wenn es sich auf den geplanten Einsatz der hergestellten Beschichtung nicht nachteilig auswirkt.

Problematisch ist jedoch die Herstellung sehr dünner Schichten. Diese enthalten einen prozentual sehr hohen Anteil minderwertigen Materials. Dieses kann auch nicht mehr entfernt werden, ohne die aufgewachsene Schicht insgesamt stark zu schwächen oder zu beschädigen. Bei einem Schichtsystem aus einer Mehrzahl dünner Schichten unterschiedlicher Zusammensetzung können die Grenzflächen nach der Herstellung der Einzelschichten unzugänglich sein, so dass die nachträgliche Entfernung des Anfänglich mit abweichender Zusammensetzung oder Kristallstruktur abgeschiedene Material nicht möglich ist.

Ausgehend vom Stand der Technik liegt der Erfindung somit die Aufgabe zugrunde, ein Verfahren zur Beschichtung anzugeben, welches auch für die Herstellung qualitativ hochwertiger dünner Schichten oder Schichtsysteme eingesetzt werden kann.

Die Aufgabe wird erfindungsgemäß durch ein Verfahren gemäß Anspruch 1 gelöst. Vorteilhafte Weiterbildungen der Erfindung finden sich in den Unteransprüchen.

Erfindungsgemäß wird eine Beschichtungsanlage verwendet, welche zumindest einen evakuierbaren Rezepienten aufweist. Der Rezipient kann in einigen Ausführungsformen aus Edelstahl oder einer Aluminiumlegierung gefertigt sein. In einigen Ausführungsformen der Erfindung besteht die Wandung des Rezipienten zumindest teilweise aus Glas oder Keramik und ist auf diese Weise für elektromagnetische Strahlung zumindest teilweise durchlässig. Der Rezipient kann mit einer an sich bekannten Vakuumpumpe, beispielsweise einer Turbomolekularpumpe, einer Kryopumpe oder einer Drehschieberpumpe evakuiert werden. Vor Beginn der Schichtabscheidung kann der Restgasdruck im Rezipienten kleiner als 1·10⁻⁶ mbar, kleiner als 1·10⁻⁷ mbar oder kleiner als 1·10⁻⁸ mbar sein.

Weiterhin enthält die Beschichtungsanlage zumindest einen Substrathalter, welcher zur Aufnahme eines Substrates vorgesehen ist. Das Substrat kann allein durch Schwerkraft auf einer ebenen Auflagefläche des Substrathalters positioniert sein. In anderen Ausführungsformen der Erfindung kann das Substrat mittels einer Klemmbefestigung oder einer Verschraubung auf dem Substrathalter fixiert werden. Hierdurch wird ein versehentliches Verschieben des Substrates bei der Bewegung des Substrathalters oder beim Evakuieren des Rezipienten verhindert.

Weiterhin enthält die Beschichtungsanlage zumindest eine Gaszufuhreinrichtung, mittels welcher zumindest ein gasförmiger Precursor in den Rezipienten einleitbar ist. Der Precursor enthält zumindest ein Gas bzw. ein Gasgemisch mit schichtbildenden Substanzen, welche bei Durchführung des Beschichtungsverfahrens auf dem Substrat abgeschieden werden. Beispielsweise kann der Precursor zur Herstellung einer Siliziumschicht Silan enthalten. Zur Herstellung einer Diamantschicht oder einer Schicht aus diamantartigem Kohlenstoff kann der Precursor einen Kohlenwasserstoff enthalten, beispielsweise Acetylen oder Methan.

Daneben kann der gasförmige Precursor ein Trägergas enthalten, beispielsweise Wasserstoff oder Edelgase. Schließlich kann der Precursor Dotierstoffe enthalten, mit welchen die aufwachsende Beschichtung an vorgebbare thermische oder elektrische Eigenschaften angepasst werden kann. Die Zusammensetzung des Precursors kann sich während der Laufzeit der Beschichtungsanlage verändern, um so ein Schichtsystem aus mehreren Einzelschichten zu erzeugen. Diese können abrupt oder gradiert ineinander übergehen.

Die Beschichtungsanlage weist weiterhin zumindest eine Plasmaerzeugungseinrichtung auf. Die Plasmaerzeugungseinrichtung kann elektromagnetische Strahlung erzeugen, welche vom gasförmigen Precursor absorbierbar ist. In Abhängigkeit des Frequenzbereiches der von der Plasmaerzeugungseinrichtung abgestrahlten elektromagnetischen Strahlung kann das Plasma ein RF-Plasma, ein Mikrowellenplasma oder ein ECR-Plasma sein. Die Plasmaerzeugungseinrichtung kann in einigen Ausführungsformen der Erfindung eine Leistung von etwa 1 kW bis etwa 10 kW oder von etwa 2 kW bis etwa 6 kW aufweisen.

Erfindungsgemäß wird nun vorgeschlagen, dass der Substrathalter innerhalb des evakuierbaren Rezepienten verschiebbar ist, sodass dieser von einer Arbeitsposition in eine Ruheposition bringbar ist. In der Arbeitsposition ist das auf dem Substrathalter angeordnete Substrat der Einwirkung des teilweise ionisierten Precursors ausgesetzt, sodass eine Schichtabscheidung auf dem Substrat erfolgt. In der Ruheposition ist die Einwirkung des ionisierten Precursors geringer, sodass keine Schichtabscheidung und in einigen Ausführungsformen der Erfindung auch kein Ätzen des Substrates durch das Plasma erfolgt. Somit kann das Substrat in der Ruheposition gelagert werden, bis sich das Plasma im Rezipienten stabilisiert hat. Erst wenn sich die gewünschten Abscheidebedingungen stabil eingestellt haben, kann das Substrat von der Ruheposition in die Arbeitsposition bewegt werden. Nachdem eine hinreichende Schichtdicke erzeugt wurde, kann das Schichtwachstum unterbrochen werden, indem der Substrathalter wiederum in die Ruheposition gebracht wird. Auf diese Weise wird vermieden, dass die abgeschiedenen Schichten eine minderwertige Kristallqualität oder eine unerwünschte Zusammensetzung aufweisen, wenn sich die Plasmabedingungen noch nicht stabilisiert haben. Somit können auch dünne Schichten in hoher Qualität abgeschieden werden.

In einigen Ausführungsformen der Erfindung kann die mit der erfindungsgemäßen Beschichtungsanschlage abgeschiedene Schicht eine Dicke von etwa 10 nm bis etwa 1 µm aufweisen. In anderen Ausführungsformen der Erfindung kann die Schichtdicke zwischen etwa 20 nm bis etwa 250 nm betragen.

In einigen Ausführungsformen der Erfindung kann der Substrathalter axial verschiebbar sein. Hierdurch ist die Erfindung durch Einsatz eines einfachen Linearantriebes leicht zu realisieren. Die Positionierung des Substrates kann mit großer Genauigkeit und dennoch geringem technischen Aufwand erfolgen.

In einigen Ausführungsformen der Erfindung kann der Substrathalter eine Heizeinrichtung aufweisen. Hierdurch kann das Substrat bereits in der Ruheposition auf die gewünschte Temperatur gebracht werden, welche optimale Eigenschaften der abgeschiedenen Schicht erwarten lässt. Hierdurch wird vermieden, dass nach dem Transport in die Arbeitsposition Anfangs unerwünschte Materialphasen abgeschieden werden, bis das Substrat durch die Einwirkung des Plasmas aufgeheizt wurde.

Sofern in der Arbeitsposition eine zusätzliche Beheizung des Substrates durch das Plasma erfolgt, kann die Heizleistung der Heizeinrichtung entsprechend reduziert werden. Hierzu kann eine Regeleinrichtung vorhanden sein, beispielsweise ein PI-Regler, ein PD-Regler oder ein PID-Regler. Durch den Einsatz der Heizeinrichtung wird vermieden, dass zu Beginn der Schichtabscheidung bei zu niedrigen Substrattemperaturen unerwünschte Phasen auf dem Substrat abgeschieden werden oder die Schichtqualität leidet. Die vorgeschlagene Regelung verhindert dabei eine Überhitzung des Substrates durch das Plasma.

In einigen Ausführungsformen der Erfindung enthält die Beschichtungsanlage ein Abschirmelement, welches eine Bohrung aufweist, durch welche der Substrathalter in die Arbeitsposition bringbar ist. Das Abschirmelement formt das elektrische Feld am Ort des Plasmas, sodass ein Substrathalter aus einem elektrisch leitfähigen Material, beispielsweise einem Metall oder einer Legierung, ohne Störung des Plasmas von der Arbeitsposition in die Ruheposition und vice versa gebracht werden kann.

In einigen Ausführungsformen der Erfindung kann der Substrathalter oder das Substrat in der Arbeitsposition mit einer dem Plasma zugewandten Seite des Abschirmelementes bündig abschließen. Dies führt dazu, dass am Übergang zwischen der Bohrung des Abschirmelementes und dem Substrat bzw. dem Substrathalter keine scharfen Kanten auftreten, welche zu einer Feldüberhöhung führen würden, welche die Ausbildung des Plasmas stören könnten. Solche Störungen können zu inhomogenem Abscheideverhalten führen, sodass die gewünschte hohe Schichtqualität nicht oder zumindest nicht vollflächig erreichbar ist.

In einigen Ausführungsformen der Erfindung kann der Rezipient die Form eines Ellipsoides aufweisen. Hierdurch kann die Mikrowellenstrahlung der Plasmaerzeugungseinrichtung fokussiert werden, sodass sich eine größere Plasmadichte und/oder ein gleichmäßigeres Plasma vor dem Substrat ausbildet.

In einigen Ausführungsformen der Erfindung kann die Plasmaerzeugungseinrichtung an der Arbeitsposition eine Leistung von mehr als 1 kW oder mehr als 3 kW oder mehr als 4 kW erzeugen. In einigen Ausführungsformen der Erfindung kann die Plasmaerzeugungseinrichtung an der Ruheposition eine Leistung von weniger als etwa 1 W oder weniger als 100 mW oder weniger als etwa 10 mW erzeugen. Hierdurch wird sichergestellt, dass das Plasma das Substrat in der Ruheposition über eine Zeitdauer von mehr als etwa 0,75 h oder mehr als etwa 2 h oder mehr als etwa 3 h weder ätzt noch unerwünschte Schichten abscheidet. In der Arbeitsposition kann hingegen eine Schicht mit einer Abscheiderate von mehr als 100 nm/h, mehr als 1 µm/h oder mehr als 3 µm/h erzeugt werden.

In einigen Ausführungsformen der Erfindung kann die Heizeinrichtung das Substrat in der Ruheposition auf eine Temperatur zwischen etwa 800°C und etwa 950°C erwärmen. Bei dieser Temperatur können beispielsweise Diamantschichten hoher Qualität abgeschieden werden, sodass das Wachstum der Schichten unmittelbar beginnt, nachdem das Substrat von der Ruhe- in die Arbeitsposition bewegt wurde.

In einigen Ausführungsformen der Erfindung kann an der Arbeitsposition zumindest eine Feldmode zumindest ein Hauptmaximum aufweisen, dessen Feldstärke gegenüber den Feldstärken benachbarter Nebenmaxima überhöht ist. Hierdurch ist es möglich, einerseits eine hohe Plasmadichte an der Arbeitsposition zu erzeugen, sodass Schichten hoher Qualität mit entsprechenden großer Abscheiderate erzeugt werden können. Darüber hinaus kann das Plasma durch entsprechende Fokussierung der elektromagnetischen Welle auf einen Bereich beschränkt werden, welcher durch das Ein- oder Ausfahren eines elektrisch leitfähigen Substrathalters nicht oder nur wenig beeinflusst wird.

Die Vorrichtung kann insbesondere dazu eingesetzt werden, homoepitaktische Diamantschichten zu erzeugen. Das bedeutet, dass eine Diamantschicht mit vorgebbarer Zusammensetzung und Dotierung auf einer bereits vorhandenen Diamantschicht abgeschieden wird. Dabei kann das Substrat zwischen der Abscheidung unterschiedlich zusammengesetzter Schichten in die Ruheposition gebracht werden, bis sich die Plasmabedingungen, insbesondere die Temperatur, die Ausdehnung, der Gasdruck und die Gaszusammensetzung stabilisiert haben. Erst wenn sich die gewünschten Abscheidebedingungen eingestellt haben, wird das Substrat von der Ruhe- in die Arbeitsposition bewegt, um eine weitere Diamantschicht homoepitaktisch abzuscheiden. Auf diese Weise können beispielsweise Halbleiterbauelemente auf der Basis von Diamant aus unterschiedlich dotierten Schichten hergestellt werden.

Nachfolgend soll die Erfindung anhand von Figuren ohne Beschränkung des allgemeinen Erfindungsgedankens näher erläutert werden. Dabei zeigt:
- Figur 1: eine Ausführungsform einer Beschichtungsanlage, bei welcher sich der Substrathalter in der Ruheposition befindet.
- Figur 2: zeigt eine Ausführungsform der Beschichtungsanlage, bei welcher sich der Substrathalter in der Arbeitsposition befindet.
- Figur 3: zeigt eine vergrößerte Ansicht eines Teils der Beschichtungsanlage in der Arbeitsposition.
- Figur 4: zeigt eine vergrößerte Ansicht eines Teils der Beschichtungsanlage in der Ruheposition.
- Figur 5: zeigt ein Flussdiagramm des erfindungsgemäßen Verfahrens.

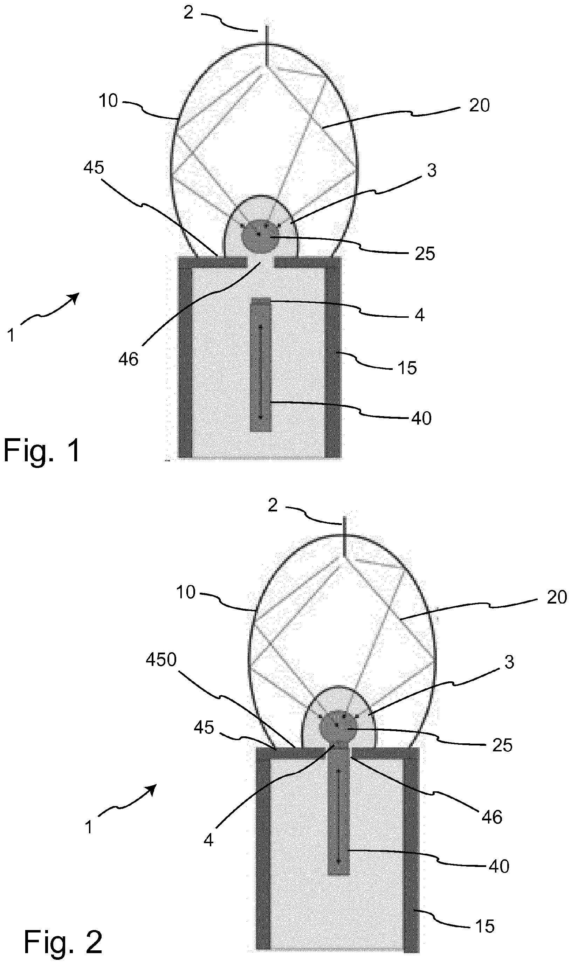

Anhand der Figuren 1 und 2 wird eine Ausführungsform der verwendeten Beschichtungsanlage näher erläutert. Die Beschichtungsanlage weist einen Rezipienten 3 auf, in welchem mittels einer nicht dargestellten Gaszufuhreinrichtung ein gasförmiger Precursor einleitbar ist. Der Rezepient 3 kann auf einen Hintergrunddruck von weniger als 1-10⁻⁶ mbar evakuiert werden. Bei Betrieb der Beschichtungsanlage 1 kann der Precursor im Rezepienten 3 einen Druck von etwa 30 mbar bis etwa 250 mbar aufweisen.

Der gasförmige Precursor enthält zumindest eine schichtbildende Substanz, welche bei Betrieb der Beschichtungsanlage 1 im Plasma zumindest teilweise ionisiert und dadurch zersetzt wird, sodass sich die schichtbildende Substanz als Beschichtung auf dem Substrat 4 niederschlägt. Die schichtbildende Substanz kann beispielsweise einen Kohlenwasserstoff enthalten, insbesondere Methan oder Acetylen. Daneben kann der Precursor Dotierstoffe enthalten, beispielsweise Stickstoff oder Bor. Der gasförmige Precursor kann in einem Trägergas verdünnt sein. Als Trägergas eignet sich beispielsweise Wasserstoff.

Die Wandung des Rezipienten 3 enthält ein dielektrisches Material, welches für elektromagnetische Strahlung zumindest teilweise durchlässig ist. Beispielsweise kann die Wandung des Rezipienten 3 zumindest teilweise aus Glas, Quarz oder Keramik bestehen.

Der Rezepient 3 ist von einem Hohlraumresonator 10 umgeben, welcher die Form eines Rotationellipsoides aufweist. Der Hohlraumresonator weist zwei Brennpunkte auf. Am oberen Brennpunkt befindet sich eine Antenne 2 einer Mikrowellenquelle. Am unteren Brennpunkt bildet sich das Plasma 25 im Precursor aus. Wie Figur 1 zeigt, wird die von der Antenne 2 in etwa isotrop ausgestrahlte Mikrowellenstrahlung 20 an den Wandungen des Hohlraumresonators 10 reflektiert und im unteren Brennpunkt fokussiert. Hierdurch trifft die Mikrowellenstrahlung am unteren Brennpunkt in etwa isotrop aus allen Raumrichtungen ein, sodass sich ein gleichmäßig dichtes Plasma 25 ausbilden kann, welches durch die Bewegung des Substrathalters nur gering oder gar nicht beeinflusst wird.

Am Boden des Rezipienten 3 befindet sich ein Abschirmelement 45, welches eine Bohrung 46 aufweist. Unterhalb der Bohrung 46 ist ein Substrathalter 40 angeordnet. An der Stirnseite des Substrathalters 40 befindet sich das Substrat 4. Der Substrathalter 40 ist mittels eines Linearantriebes bewegbar. Das Substrat kann durch eine optionale Klemmung gehalten werden oder mit einem optionalen Load lock in der Ruheposition des Substrathalters 40 eingeführt oder entnommen werden.

In Figur 1 ist der Substrathalter 40 in der Ruheposition dargestellt. Diese zeichnet sich dadurch aus, dass das Plasma 25 durch das Abschirmelement 45 weitgehend auf den oberen Teil des Rezipienten 3 beschränkt bleibt, sodass das Plasma 25 nicht oder nur mit vernachlässigbarer Intensität auf die Oberfläche des Substrates 4 einwirkt. Auf dem Substrat 4 wird daher zumindest während einer Zeitdauer von mehr als 45 min oder mehr als 2 h keine zusammenhängende Schicht aus der Gasphase abgeschieden.

In Figur 2 ist der Substrathalter 40 in der Arbeitsposition dargestellt. Diese zeichnet sich dadurch aus, dass die Spitze des Substrathalters 40 durch die Bohrung 46 ragt und das Substrat 4 in etwa auf einer Ebene mit dem Abschirmelement 45 zu liegen kommt. In dieser Position kann die Oberfläche des Substrates 4 in etwa bündig mit der dem Plasma zugewandten Vorderseite 450 des Abschirmelementes 45 sein.

In der Arbeitsposition wird auf dem Substrat 4 eine Schicht aus dem Plasma 25 abgeschieden. Das Schichtwachstum kann mit einer Rate von mehr als 100 nm/h, mehr als 1000 nm/h oder mehr als 2 µm/h erfolgen. In einigen Ausführungsformen der Erfindung ist die Abscheiderate des Precursors auf dem Substrat 4 in der Arbeitsposition um mehr als einen Faktor 10⁴, mehr als einen Faktor 10⁶ oder mehr als einen Faktor 10⁸ gegenüber der Ruheposition erhöht.

Erfindungsgemäß wird nun vorgeschlagen, das Substrat 4 in die oben dargestellte Ruheposition zu bringen, dann den gasförmigen Precursor in der gewünschten Zusammensetzung in den Rezipienten 3 einzuleiten und durch die Mikrowellenstrahlung der Plasmaerzeugungseinrichtung das Plasma 25 auszubilden. Aufgrund des Abschirmelementes 45 und der Fokussierung der Mikrowellenstrahlung im Hohlraumresonator 10 wird das Plasma 25 durch die Bohrung 46 und die dadurch auftretende Feldverzerrung nicht oder nur geringfügig beeinflusst. Die Beschichtungsanlage kann somit solange betrieben werden, bis sich ein stabiles Plasma ausgebildet hat. Dies kann in einigen Ausführungsformen der Erfindung mehr als 30 Minuten, mehr als 40 Minuten oder mehr als 60 Minuten andauern. Während dieser Zeit wird das Substrat 4 nicht aus dem Plasma 25 beschichtet, sodass sich auch keine Schicht mit unerwünschter Zusammensetzung oder sonstigen unerwünschten Schichteigenschaften ausbildet.

Wenn das Plasma 25 stabil im Rezipienten 3 brennt, kann das Substrat in die Arbeitsposition gebracht werden, sodass die Schichtabscheidung auf dem Substrat 4 erfolgt.

Sobald die Schicht in der gewünschten Dicke und Zusammensetzung erzeugt wurde, kann das Substrat 4 zur Unterbrechung des Wachstums wieder in die Ruheposition gebracht werden. Sofern auf der ersten erzeugten Schicht eine zweite Schicht abgeschieden werden soll, kann der Druck oder die Zusammensetzung des Precursors, die Temperatur des Substrates und/oder die Mikrowellenleistung an die neuen Sollwerte angepasst werden. Sobald sich die Bedingungen im Rezipienten 3 wieder stabilisiert haben, kann das Substrat 4 wieder in die Arbeitsposition verbracht werden, um die zweite Schicht abzuscheiden.

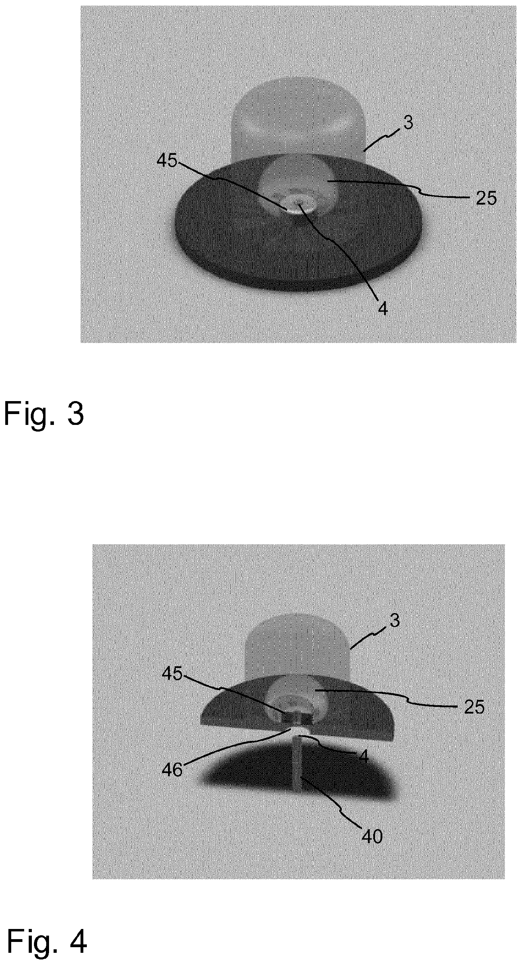

Anhand der Figuren 3 und 4 wird nochmals ein Ausschnitt der in den Figuren 1 und 2 dargestellten Beschichtungsanlage in größerer Genauigkeit dargestellt. Gleiche Bezugszeichen bezeichnen gleiche Bestandteile der Erfindung, sodass die nachfolgende Beschreibung kurz gehalten werden kann.

Figur 3 zeigt das Substrat 4 in der Arbeitsposition, in welcher eine Schichtabscheidung stattfindet. Demgegenüber zeigt Figur 4 das Substrat 4 in der Ruheposition, in welcher das Substrat 4 durch das Abschirmelement 45 von der Einwirkung des Plasmas 25 geschützt ist.

Das Plasma 25 bildet sich in einem Rezipienten 3 aus, welcher aus einem für die Mikrowellenstrahlung durchlässigen Material gefertigt ist. Beispielsweise kann der Rezipient 3 aus Quarz oder Glas bestehen. Das Abschirmelement 4 kann aus einem Metall oder einer Legierung gefertigt sein und kann mittels einer Spannungsquelle auf einem vorgebbaren Potenzial gehalten werden. Dieses Potenzial kann mit dem für die Abscheidung der Schicht gewählten Biaspotenzial identisch sein, sodass das Plasma 25 stabil weiterbrennt, wenn der Substrathalter 40 von der Ruhe- in die Arbeitsposition und zurückbewegt wird.

Hierzu kann das Abschirmelement 45 eine Bohrung 46 aufweisen, deren Fläche klein gegenüber der Gesamtfläche des Abschirmelementes 45 ist. Somit bestimmt das Abschirmelement 45 das Potenzial im Rezipienten 3, welches von den sich bei der Bewegung des Substrathalters ändernden Potentialverhältnissen an der Fläche der Bohrung 46 nur geringfügig oder gar nicht beeinflusst wird.

In einigen Ausführungsformen der Erfindung kann der Rezipient 3 entfallen. In diesem Fall kann der Hohlraumresonator 10 als Rezipient verwendet werden und vollständig mit dem Precursor gefüllt sein.

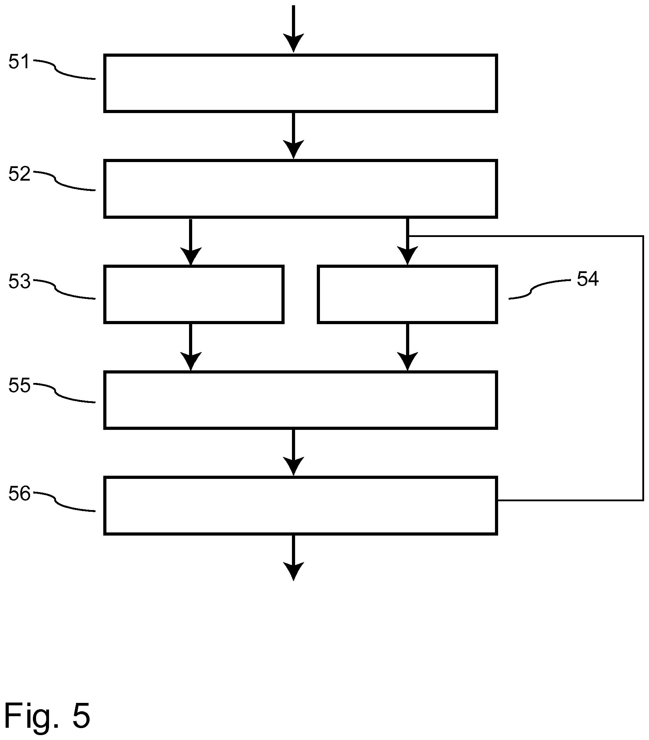

Anhand der Figur 5 wird der Ablauf des erfindungsgemäßen Beschichtungsverfahrens nochmals erläutert. Im ersten Verfahrensschritt 51 wird der Substrathalter 40 in seine Ruheposition verfahren. In der Ruheposition ist ein auf dem Substrathalter 40 angeordnetes Substrat 4 zum einen vor der Einwirkung des Plasmas 25 geschützt. Zum anderen kann ein Substrat mittels eines Manipulators und einer Schleuse vom Substrathalter entfernt oder auf den Substrathalter aufgebracht werden, ohne den Rezipient zu belüften.

Im zweiten Verfahrensschritt 52 wird daher ein zur Beschichtung vorgesehenes Substrat 4 auf den Substrathalter 40 aufgebracht. In einigen Ausführungsformen der Erfindung kann das Substrat einen einkristallinen Diamant enthalten oder daraus bestehen. Der Diamant kann beispielsweise heteroepitaktisch auf einen Molybdän- oder Siliziumsubstrat erzeugt worden sein und nachfolgend vom Substrat getrennt worden sein. In anderen Ausführungsformen der Erfindung kann der Diamant in einem HPHT-Verfahren hergestellt worden sein. Die Erfindung lehrt nicht die Verwendung eines speziellen Substrates als Lösungsprinzip.

Wenn das Substrat 4 auf dem Substrathalter 40 angeordnet wurde, kann im dritten Verfahrensschritt 53 mittels einer im Substrathalter 40 angeordneten Heizeinrichtung das Substrat auf eine vorgebbare Temperatur gebracht werden. Im Falle einer Diamantabscheidung kann die Temperatur beispielsweise zwischen 800° und etwa 850°C betragen. Zeitgleich kann der vierte Verfahrensschritt 54 durchgeführt werden. Im vierten Verfahrensschritt 54 wird ein gasförmiger Precursor in den Rezipienten 3 eingeleitet. Der Precursor kann beispielsweise Wasserstoff und Methan enthalten, um eine nominell undotierte Diamantschicht homoepitaktisch auf dem Substrat 4 abzuscheiden. Die einzelnen Bestandteile des Precursors werden mit vorgebbaren Massenflüssen in den Rezepienten 3 eingeleitet und die Mikrowellenstrahlung der Plasmaerzeugungseinrichtung 2 wird aktiviert. Dies führt zum Ausbilden eines Plasmas 25, welches anfangs noch instabil brennt. Dies bedeutet, dass sich die Plasmadichte, die Temperatur und Zusammensetzung fortlaufend ändern, so dass keine homogene Schicht mit den gewünschten Eigenschaften erzeugt werden könnte.

Die Verfahrensschritte 53 und 54 dauern solange an, bis das Plasma 25 stabil brennt, d. h. die Plasmadichte, die Plasmazusammensetzung und die Plasmatemperatur sind im Rahmen üblicher Messgenauigkeiten konstant. Der Verfahrensschritt 53 wird solange fortgeführt, bis sich eine stabile Temperatur des Substrates eingestellt hat. Dies kann mittels einer Regeleinrichtung und/oder einer nicht dargestellten Messeinrichtung überwacht und geregelt werden.

Nach Abschluss der Verfahrensschritte 53 und 54, welche in anderen Ausführungsformen der Erfindung auch sequenziell durchgeführt werden können, wird das Substrat im fünften Verfahrensschritt 55 in die Arbeitsposition verfahren. Nachfolgend erfolgt die Schichtabscheidung auf dem Substrat 4. Da das Plasma 25 bereits stabil brennt und keine zeitlich wechselnde Zusammensetzung aufweist, wächst die gewünschte Schicht von Anfang an in hoher Qualität auf. Auch am Übergang zur Substratoberfläche bilden sich keine unerwünschten Phasen mit abweichender Kristallstruktur oder abweichender chemischer Zusammensetzung.

Nachdem die gewünschte Schicht in der gewünschten Schichtdicke abgeschieden wurde, wird der Substrathalter 40 wieder in die Ruheposition verbracht. Hierdurch stoppt die Schichtabscheidung instantan. Somit lässt sich mit der erfindungsgemäßen Vorrichtung die Schichtdicke sehr genau kontrollieren. Auch dünne Schichten können mit hoher Qualität abgeschieden werden, da instabile Plasmazustände nicht auf das Substrat einwirken können.

Sofern auf der soeben erzeugten Schicht eine weitere Schicht mit anderer Zusammensetzung oder Kristallstruktur erzeugt werden soll, kann der vierte Verfahrensschritt 54 erneut durchgeführt werden. Beispielsweise kann nun zusätzlich ein Dotierstoff in den Rezipienten 3 eingebracht werden. Wenn das Plasma erneut stabil brennt, wird der Substrathalter 40 im Verfahrensschritt 55 wieder in die Arbeitsposition verbracht. Nach Abschluss der Schichtabscheidung wird der Substrathalter im sechsten Verfahrensschritt 56 wieder in die Ruheposition verbracht.

Die Verfahrensschritte 54, 55 und 56 werden solange wiederholt, bis die gewünschte Schichtenfolge abgeschieden ist. Danach wird das Substrat abgekühlt und aus der Beschichtungsanlage entnommen.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Aus-führungsform der Erfindung vorhanden ist. Dies schließt die Anwesenheit weiterer Merkmale nicht aus. Sofern die Ansprüche und die vorstehende Beschreibung "erste" und "zweite" Aus-führungsformen definieren, so dient diese Bezeichnung der Unterscheidung zweier gleichartiger Ausführungsformen, ohne eine Rangfolge festzulegen. Sofern die Ansprüche und die vorstehende Beschreibung "erste" und "zweite" Merkmale definieren, so dient diese Bezeichnung der Unterscheidung zweier gleichartiger Merkmale, ohne eine Rangfolge festzulegen.

## Patentansprüche

1. Verfahren zur Beschichtung eines Substrates, bei welchem das Substrat (4) mit einem Substrathalter (40) in einen evakuierbaren Rezipienten (10) eingebracht wird, mit zumindest einer Gaszufuhreinrichtung zumindest ein gasförmiger Prekursor in den Rezipienten (10) eingeleitet wird und mit zumindest einer Plasmaerzeugungseinrichtung (2) der Precursor zumindest teilweise ionisiert wird, **dadurch gekennzeichnet, dass**
im Rezipienten (10) ein Abschirmelement (45) enthalten ist, welches eine Bohrung (46) aufweist, durch welche der Substrathalter in eine Arbeitsposition gebracht wird, wobei das Plasma (25) gezündet wird, so lange sich der Substrathalter (40) mit dem Substrat (4) in einer Ruheposition befindet und der Substrathalter (40) nach einer vorgebbaren Zeitspanne in die Arbeitsposition bewegt wird.

2. Verfahren nach Anspruch 1, **dadurch gekennzeichnet, dass** die Plasmaerzeugungseinrichtung (2) an der Arbeitsposition eine Leistung von mehr als 1 kW oder mehr als 3 kW oder mehr als 4 kW erzeugt und/oder dass die Plasmaerzeugungseinrichtung (2) an der Ruheposition eine Leistung von weniger als als 1 W oder weniger als 100 mW oder weniger als 10 mW erzeugt.

3. Verfahren nach einem der Ansprüche 1 bis 2, **dadurch gekennzeichnet, dass** die vorgebbare Zeitspanne zwischen etwa 10 min und etwa 60 min beträgt oder
dass die vorgebbare Zeitspanne zwischen etwa 30 min und etwa 45 min beträgt.

4. Verfahren nach einem der Ansprüche 1 bis 3, **dadurch gekennzeichnet, dass** das Substrat (4) in der Ruheposition auf eine Temperatur zwischen etwa 800°C und etwa 950°C gebracht wird.

5. Verfahren nach einem der Ansprüche 1 bis 4, **dadurch gekennzeichnet, dass** die Temperatur des Substrats (4) an der Ruheposition und an der Arbeitsposition konstant gehalten wird.

6. Verfahren nach einem der Ansprüche 1 bis 4, **dadurch gekennzeichnet, dass** die Plasmaerzeugungseinrichtung (2) einen Mikrowellensender enthält und an der Arbeitsposition zumindest eine Feldmode zumindest ein Hauptmaximum aufweist, dessen Feldstärke gegenüber den Feldstärken benachbarter Nebenmaxima überhöht ist.

7. Verfahren nach einem der Ansprüche 1 bis 6, **dadurch gekennzeichnet, dass** in der Arbeitsposition auf dem Substrat (4) Diamant abgeschieden wird.

8. Verfahren nach Anspruch 7, **dadurch gekennzeichnet, dass** der Diamant eine Dicke von etwa 10 nm bis etwa 50 nm oder von etwa 20 nm bis etwa 40 nm aufweist

9. Verfahren nach einem der Ansprüche 7 oder 8, **dadurch gekennzeichnet, dass** der Diamant homoepitaktisch abgeschieden wird.

10. Verfahren nach einem der Ansprüche 1 bis 9, **dadurch gekennzeichnet, dass** der Rezipient die Form eines Ellipsoides aufweist.

11. Verfahren nach einem der Ansprüche 1 bis 9, **dadurch gekennzeichnet, dass** der Rezipient (3) von einem Hohlraumresonator (10) umgeben ist, welcher die Form eines Ellipsoides aufweist.

12. Verfahren nach Anspruch 10 oder 11, **dadurch gekennzeichnet, dass** die Plasmaerzeugungseinrichtung (2) einen Mikrowellensender enthält und in einem ersten Brennpunkt des Ellipsoides angeordnet ist und das Substrat (4) in der Arbeitposition des Substrathalters (40) in einem zweiten Brennpunkt des Ellipsoides angeordnet ist.

13. Verfahren nach einem der Ansprüche 1 bis 12, **dadurch gekennzeichnet, dass** der Substrat¬halter (40) mit dem Substrat (4) von der Ruheposition in die Arbeitsposition axial verschoben wird.

14. Verfahren nach einem der Ansprüche 1 bis 13, **dadurch gekennzeichnet, dass** der Substrathalter (40) oder das Substrat (4) in der Arbeitsposition mit einer dem Plasma zugewandetn Seite (450) des Abschirmelementes (45) bündig abschließt.

## Claims

1. Method for coating a substrate, in which the substrate (4) is brought into an evacuable recipient (10) by means of a substrate holder (40), at least one gaseous precursor is introduced into the recipient (10) by means of at least one gas supply device and the precursor is at least partially ionized by means of at least one plasma generating device (2), **characterized in that**
the recipient (10) contains a shielding element (45), which has a hole (46), through which the substrate holder is brought into a working position, the plasma (25) being ignited as long as the substrate holder (40) with the substrate (4) is in a rest position and the substrate holder (40) is moved into the working position after a predeterminable period of time.

2. Method according to claim 1, **characterized in that**, at the working position, the plasma generating device (2) has a power of more than 1 kW or more than 3 kW or more than 4 kW and/or
**in that**, at the rest position, the plasma generating device (2) generates a power of less than 1 W or less than 100 mW or less than 10 mW.

3. Method according to any one of claims 1 to 2, **characterized in that** the predeterminable time period is between about 10 min and about 60 min or
**in that** the predeterminable time period is between about 30 min and about 45 min.

4. Method according to any one of claims 1 to 3, **characterized in that** the substrate (4) is brought to a temperature between about 800°C and about 950°C in the rest position.

5. Method according to any one of claims 1 to 4, **characterized in that** the temperature of the substrate (4) is kept constant at the rest position and at the working position.

6. Method according to any one of claims 1 to 4, **characterized in that** the plasma generating device (2) contains a microwave transmitter and, at the working position, at least one field mode has at least one main maximum, the field strength of which is higher than the field strengths of adjacent secondary maxima.

7. Method according to any one of claims 1 to 6, **characterized in that** diamond is deposited on the substrate (4) in the working position.

8. Method according to claim 7, **characterized in that** the diamond has a thickness from about 10 nm to about 50 nm or from about 20 nm to about 40 nm.

9. Method according to any one of claims 7 or 8, **characterized in that** the diamond is deposited homoepitaxially.

10. Method according to any one of claims 1 to 9, **characterized in that** the recipient has the shape of an ellipsoid.

11. Method according to any one of claims 1 to 9, **characterized in that** the recipient (3) is surrounded by a cavity resonator (10), which has the shape of an ellipsoid.

12. Method according to claim 10 or 11, **characterized in that** the plasma generating device (2) contains a microwave transmitter and is arranged in a first focal point of the ellipsoid and the substrate (4) is arranged in the working position of the substrate holder (40) in a second focal point of the ellipsoid.

13. Method according to any one of claims 1 to 12, **characterized in that** the substrate holder (40) with the substrate (4) is axially moved from the rest position to the working position

14. Method according to any one of claims 1 to 13, **characterized in that**, in the working position, the substrate holder (40) or the substrate (4) is flush with one side (450) of the shielding element (45) that faces the plasma.

## Revendications

1. Procédé de revêtement d'un substrat, dans lequel le substrat (4) est introduit dans un récipient (10), pouvant être mis sous vide, au moyen d'un porte-substrat (40), au moins un précurseur gazeux est introduit dans le récipient (10) au moyen d'au moins un dispositif d'alimentation en gaz, et le précurseur est au moins partiellement ionisé au moyen d'au moins un dispositif de génération de plasma (2),
**caractérisé en ce que**
un élément de protection (45) est inclus dans le récipient (10), qui présente un alésage (46) à travers lequel le porte-substrat est amené dans une position de travail,
le plasma (25) est allumé tant que le porte-substrat (40) avec le substrat (4) se trouve dans une position de repos et le porte-substrat (40) est déplacé vers la position de travail après un laps de temps prédéfinissable.

2. Procédé selon la revendication 1,
**caractérisé en ce que** le dispositif de génération de plasma (2) génère, en position de travail, une puissance supérieure à 1 kW ou supérieure à 3 kW ou supérieure à 4 kW, et/ou
**en ce que** le dispositif de génération de plasma (2) génère, en position de repos, une puissance inférieure à 1 W ou inférieure à 100 mW ou inférieure à 10 mW.

3. Procédé selon l'une des revendications 1 à 2,
**caractérisé en ce que** le laps de temps prédéfinissable est compris entre environ 10 min et environ 60 min, ou
**en ce que** le laps de temps prédéfinissable est compris entre environ 30 min et environ 45 min.

4. Procédé selon l'une des revendications 1 à 3,
**caractérisé en ce que** dans la position de repos, le substrat (4) est porté à une température comprise entre environ 800 °C et environ 950 °C.

5. Procédé selon l'une des revendications 1 à 4,
**caractérisé en ce que** dans la position de repos et dans la position de travail, la température du substrat (4) est maintenue constante.

6. Procédé selon l'une des revendications 1 à 4,
**caractérisé en ce que** le dispositif de génération de plasma (2) comprend un émetteur de micro-ondes, et dans la position de travail, au moins un mode de champ présente au moins un maximum principal dont l'intensité de champ est surélevée par rapport aux intensités de champ des maxima secondaires voisins.

7. Procédé selon l'une des revendications 1 à 6,
**caractérisé en ce que** dans la position de travail, du diamant est déposé sur le substrat (4).

8. Procédé selon la revendication 7,
**caractérisé en ce que** le diamant présente une épaisseur d'environ 10 nm à environ 50 nm ou d'environ 20 nm à environ 40 nm.

9. Procédé selon l'une des revendications 7 ou 8,
**caractérisé en ce que** le diamant est déposé par homo-épitaxie.

10. Procédé selon l'une des revendications 1 à 9,
**caractérisé en ce que** le récipient a la forme d'un ellipsoïde.

11. Procédé selon l'une des revendications 1 à 9,
**caractérisé en ce que** le récipient (3) est entouré d'une cavité résonante (10) qui présente la forme d'un ellipsoïde.

12. Procédé selon la revendication 10 ou 11,
**caractérisé en ce que** le dispositif de génération de plasma (2) comprend un émetteur de micro-ondes et est disposé dans un premier foyer de l'ellipsoïde, et le substrat (4) est disposé dans un deuxième foyer de l'ellipsoïde, dans la position de travail du porte-substrat (40).

13. Procédé selon l'une des revendications 1 à 12,
**caractérisé en ce que** le porte-substrat (40) avec le substrat (4) est déplacé axialement de la position de repos à la position de travail.

14. Procédé selon l'une des revendications 1 à 13,
**caractérisé en ce que**, dans la position de travail, le porte-substrat (40) ou le substrat (4) se termine en affleurement avec une face (450) de l'élément de protection (45) qui est tournée vers le plasma.
